# FASCICULE DE BREVET EUROPEEN

(11) **EP 1 190 285 B1**
(45) Date de publication et mention de la délivrance du brevet: **31.05.2006**
(21) Numéro de dépôt: 01928019.7
(22) Date de dépôt: 20.04.2001
(51) Int. Cl.: G05D 27/02, H01L 21/00, G05D 16/20

(54) **PROCEDE ET DISPOSITIF DE CONDITIONNEMENT DE L'ATMOSPHERE DANS UNE CHAMBRE DE PROCEDES**
VERFAHREN UND VORRICHTUNG ZUR KONDITIONIERUNG DER ATMOSPHÄRE IN EINEM PROZESSRAUM
METHOD AND DEVICE FOR CONDITIONING ATMOSPHERE IN A PROCESS CHAMBER

(30) Priorité: 20.04.2000 FR 0005094
(43) Date de publication de la demande: 27.03.2002
(73) Titulaire: ALCATEL, 75008 Paris (FR)
(72) Inventeur: BERNARD, Roland, F-74540 Viuz la Chiesaz (FR); CHEVALIER, Eric, F-74940 Annecy le Vieux (FR); SOGAN, Gloria, F-74330 Epagny (FR)
(74) Mandataire: Poncet, Jean-François
(86) Numéro de dépôt international: PCT/FR2001/001220
(87) Numéro de publication internationale: WO 2001/082019

(56) Documents cités:
- EP-A- 0 809 284
- WO-A-98/48168
- WO-A-99/18405
- GB-A- 2 183 552

## Description

### DOMAINE TECHNIQUE DE L'INVENTION

La présente invention concerne les procédés et dispositifs assurant le pompage des gaz dans une chambre de procédés telle que celles utilisées dans la fabrication des composants électroniques à semi-conducteurs.

Dans la fabrication des composants électroniques à semi-conducteurs, une étape importante consiste à traiter un substrat semi-conducteur sous atmosphère contrôlée à très basse pression, par exemple pour des dépôts par plasma de couches de différents matériaux.

Dans une production industrielle, les substrats, sous forme de tranche, sont conditionnés et amenés en succession dans une chambre de procédés, au moyen d'un sas ou d'une chambre de transfert (EP-O 809 284) - Dans la chambre de procédés, l'atmosphère doit être contrôlée de façon très précise, notamment pour éviter la présence de toute impureté et de toute pollution.

Les progrès réalisés lors de ces dernières années dans l'industrie du semi-conducteur sont essentiellement liés à l'accroissement de l'intégration de circuits électroniques sur des composants de quelques mm², définis sur des tranches de silicium de plus en plus grandes.

Les étapes technologiques nécessaires à la réalisation de tels circuits sont nombreuses (jusqu'à 400) et, au cours du procédé, la pression dans la chambre de procédés subit des variations brusques entre différentes étapes au cours desquelles la pression doit être contrôlée et fixée à une valeur appropriée.

La génération de l'atmosphère contrôlée à basse pression dans la chambre de procédés nécessite l'utilisation de systèmes de pompage efficaces (WO-98/48168). Les systèmes utilisés comprenent généralement une pompe primaire refoulant à l'atmosphère et dont l'entrée est raccordée à la sortie d'une pompe secondaire telle qu'une pompe turbomoléculaire dont l'entrée est reliée à la chambre de procédés.

Les étapes de procédé dans la chambre de procédés nécessitent la présence de gaz particuliers, et génèrent par action sur le substrat des composés gazeux qu'il faut évacuer. Il en résulte que le système de pompage doit pomper une atmosphère variable contenant des composés gazeux qu'il faut traiter par un dispositif de traitement des gaz, afin de refouler à l'atmosphère uniquement des composés inoffensifs.

Actuellement, les systèmes de pompage et de traitement des gaz sont à distance de la chambre de procédés, c'est-à-dire qu'ils sont reliés à la chambre de procédés par des canalisations longues et coûteuses, de plus d'une dizaine de mètres.

La raison de la présence de cette distance et de ces canalisations est que les systèmes actuels de pompage et de traitement des gaz sont lourds et encombrants, et génèrent des nuisances telles que des vibrations qu'il faut absolument éviter dans la chambre de procédés.

Une usine de fabrication de composants électroniques est pour cela actuellement conçue dans un bâtiment ayant au moins deux niveaux, le niveau supérieur contenant la ou les chambres de procédés, le niveau inférieur contenant le ou les dispositifs de pompage et de traitement des gaz. Des canalisations relient les deux niveaux, pour transmettre le vide.

Les canalisations, qui sont indispensables dans les structures connues, présentent plusieurs inconvénients :
- les canalisations elles-mêmes génèrent des vibrations ;
- les canalisations constituent une importante zone surfacique sur laquelle les gaz pompés peuvent se déposer sous forme de particules ; les particules ainsi déposées peuvent rétrodiffuser de la canalisation vers la chambre de procédés, et ainsi accroître la contamination de la chambre lors des étapes ultérieures du procédé ;
- les canalisations nécessitent des moyens de support mécaniques importants ;
- pour réduire les dépôts dans les canalisations, il est possible d'effectuer un contrôle thermique, mais un tel contrôle est extrêmement coûteux et très difficile à mettre en oeuvre ;
- il est nécessaire de prévoir un système de contrôle et de surveillance lourd à mettre en oeuvre pour la sécurité en cas de fuite, les gaz pompés étant nocifs ;
- l'encombrement très important de l'ensemble nécessite des infrastructures importantes et une grande surface au sol pour les usines de production ; le coût en est très élevé ; la déperdition sur la ligne de froid n'est pas négligeable.

### EXPOSE DE L'INVENTION

Le but de l'invention est d'intégrer au voisinage immédiat de la chambre de procédés les différents éléments composant la ligne de vide, en supprimant ainsi les problèmes liés aux canalisations. On cherche à concevoir ainsi un système pouvant se connecter directement sur la chambre de procédés, et diriger ainsi plus rapidement les effluents vers les dispositifs de traitement des gaz, améliorant ainsi leur efficacité.

Mais un problème est alors que la proximité immédiate des organes actifs de la ligne de vide entraîne un risque accru de pollution de la chambre de procédés, cette pollution pouvant notamment être chimique, thermique ou mécanique. Par exemple, la proximité de la chambre de procédés provoque des dépôts de particules sur les organes actifs de la ligne de vide tels que les pompes ou les vannes, augmentant ainsi les risques de pollution par rétrodiffusion vers la chambre de procédés.

Pour cela, l'invention vise à la fois à abaisser le coût des installations en évitant la présence des canalisations entre la chambre de procédés et le dispositif de pompage et de traitement des gaz, et à réduire les risques de pollution de la chambre de procédés.

Un autre objectif de l'invention est de faciliter l'adaptation du système de pompage à des structures diverses de chambre de procédés, en optimisant l'efficacité du contrôle processus dans la chambre de procédés.

Un autre objectif de l'invention est d'améliorer l'efficacité du traitement des gaz, afin d'annuler ou de réduire dans des proportions convenables le rejet de matière toxique vers l'atmosphère.

Un autre problème résultant de la proximité immédiate des organes actifs de la ligne de vide par rapport à la chambre de procédés est que ces organes actifs risquent d'occuper une place non négligeable autour de la chambre de procédés, et d'empêcher ainsi la circulation des usagers autour des chambres de procédés et la disposition d'autres appareillages pouvant être nécessaires.

Un autre objectif de l'invention est ainsi de laisser libre l'espace de circulation autour des chambres de procédés, en évitant que les organes actifs de la ligne de vide occupent cet espace de circulation.

Un autre objectif de l'invention est de permettre la disposition des moyens de pompage à proximité immédiate de la chambre de procédés, notamment en réduisant leur taille.

Pour atteindre ces objectifs ainsi que d'autres, l'invention prévoit un procédé de conditionnement de l'atmosphère dans une chambre de procédés pour le traitement d'un substrat selon la revendication 1.

Selon un mode de réalisation avantageux, pour l'ajustement de la vitesse de pompage en fonction des gaz pompés, on utilise une fonction de transfert préalablement enregistrée représentant, pour chaque mélange gazeux présent dans la chambre de procédés au cours du traitement, la relation entre la vitesse de pompage, le flux de mélange gazeux présent, et la pression qui en résulte dans la chambre de procédés.

Grâce à un contrôle amélioré des gaz pompés, on peut avantageusement prévoir que ladite au moins une pompe secondaire est raccordée à la chambre de procédés par une canalisation de longueur inférieure à trois mètres.

Par exemple, ladite au moins une pompe secondaire est adjacente à la chambre de procédés.

De préférence, selon l'invention, on intègre la fonction de traitement de gaz dans la ligne de pompage, en :
- traitant les gaz en aval de la pompe primaire,
- analysant les gaz au refoulement de la pompe primaire avant traitement des gaz, pour connaître leur nature et leur état et pour adapter des paramètres de pompage, constitués parmi la température de la pompe primaire, une injection de gaz de dilution dans la pompe primaire, la vitesse de la pompe primaire, afin d'optimiser l'efficacité de leur traitement.

De préférence, on analyse aussi les gaz en sortie de traitement pour adapter le traitement en fonction du résultat de ladite analyse. On peut éventuellement interrompre le pompage en cas de défaut de traitement détecté par ladite analyse des gaz en sortie de traitement.

Pour faciliter l'adaptation des moyens de pompage à des structures diverses de chambre de procédés, on peut avantageusement prévoir que, au cours d'une étape préalable d'apprentissage, on fait varier la vitesse de pompage en présence de certains au moins des mélanges gazeux susceptibles d'être présente au cours des étapes de traitement dans la chambre de procédés et on mesure la pression qui en résulte dans la chambre de procédés, pour déterminer ladite fonction de transfert.

L'invention prévoit également un dispositif de conditionnement de l'atmosphère dans une chambre de procédés pour le traitement d'un substrat, selon un procédé tel que défini ci-dessus, comprenant une ligne de pompage comportant une pompe primaire sèche à vitesse variable et au moins une pompe secondaire amont. Le dispositif comprend également :
- des moyens de commande de vitesse de pompe primaire,
- des premiers moyens analyseurs de gaz adaptés pour analyser les gaz aspirés en amont de la pompe primaire, et pour produire des premiers signaux d'analyse de gaz,
- des premiers moyens de traitement de signal pour produire un signal de commande de vitesse en fonction desdits premiers signaux d'analyse de gaz procurés par les premiers moyens analyseurs de gaz, et pour transmettre ledit signal de commande de vitesse aux moyens de commande de vitesse de pompe primaire.

Selon un mode de réalisation avantageux, les premiers moyens de traitement de signal réalisent une correspondance relationnelle entre les premiers signaux d'analyse à leur entrée et le signal de commande de vitesse à leur sortie, à partir d'une fonction de transfert préalablement enregistrée représentant, pour chaque mélange gazeux présent dans la chambre de procédés au cours du traitement du substrat, une relation entre la vitesse de pompage, le flux du mélange gazeux présent, et la pression qui en résulte dans la chambre de procédés.

De préférence, le dispositif selon l'invention comprend :
- en aval de la pompe primaire, des moyens de traitement des gaz aspirés,
- au refoulement de la pompe primaire, des seconds moyens analyseurs de gaz déterminant la nature et l'état des gaz pompés et produisant des seconds signaux d'analyse de gaz,
- des seconds moyens de traitement de signal pour produire, en fonction des seconds signaux d'analyse de gaz, des seconds signaux de commande de la vitesse de la pompe primaire.

Selon un mode de réalisation avantageux, permettant d'améliorer encore le fonctionnement de la chambre de procédés, la pompe primaire, les moyens de traitement des gaz et les moyens analyseurs de gaz sont enfermés ensemble dans une enceinte d'isolement.

Selon un autre mode de réalisation avantageux, permettant de libérer l'espace de circulation autour des chambres de procédés, la chambre de procédés est contenue dans une salle ayant un faux-plancher recouvrant un espace disponible ; la pompe primaire, les moyens de traitement des gaz et les moyens analyseurs de gaz sont logés dans l'espace disponible sous le faux-plancher, à proximité de la chambre de procédés.

Selon une première alternative, le faux-plancher comprend des dalles amovibles recouvrant la pompe primaire, les moyens de traitement des gaz et les moyens analyseurs de gaz.

Selon une seconde alternative, la partie supérieure de la pompe primaire et la partie supérieure des moyens de traitement des gaz constituent elles-mêmes des portions de surface du faux-plancher.

Une plaque support peut avantageusement être disposée dans le plancher au-dessous de la pompe primaire et des moyens de traitement des gaz.

### DESCRIPTION SOMMAIRE DES DESSINS

D'autres objets, caractéristiques et avantages de la présente invention ressortiront de la description suivante de modes de réalisation particuliers, faite en relation avec les figures jointes, parmi lesquelles:
- la figure 1 est une vue schématique structurelle d'un dispositif de pompage et de traitement des gaz selon un mode de réalisation de la présente invention ;
- la figure 2 illustre le diagramme temporel de la variation de pression avant, pendant et après une étape de traitement dans une chambre de procédés ;
- la figure 3 est un diagramme dans l'espace illustrant une fonction de transfert pour un gaz pompé, donnant la relation entre la vitesse de pompage, le flux de pompage et la pression obtenue dans la chambre de procédés ; et
- la figure 4 est une vue schématique structurelle d'un dispositif selon un autre mode de réalisation de l'invention.

### DESCRIPTION DES MODES DE REALISATION PREFERES

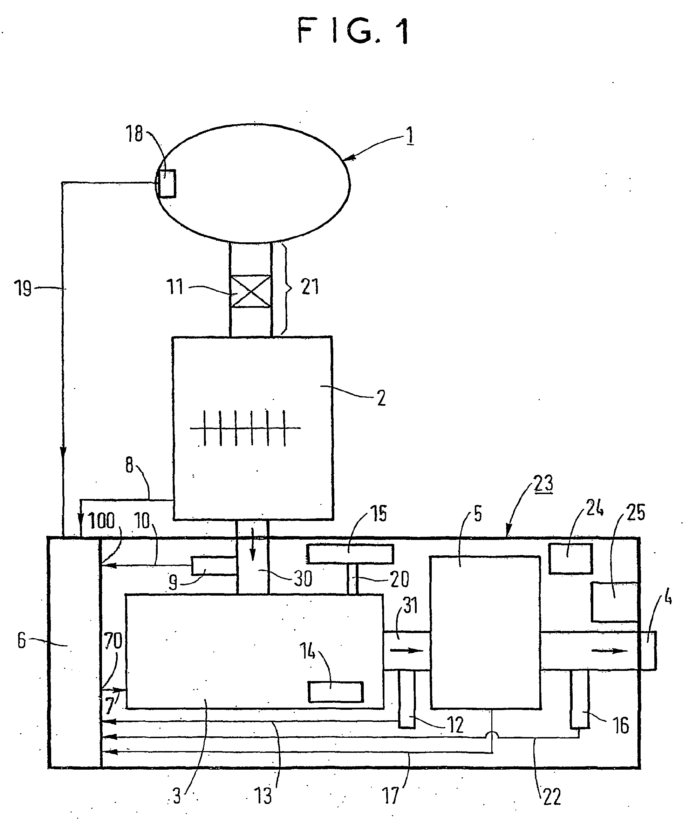

Comme illustré sur la figure 1, le système selon l'invention permet de contrôler principalement la pression régnant à l'intérieur d'une chambre de procédés 1, par pompage à l'aide d'une ligne de pompage comprenant essentiellement une pompe secondaire 2 ayant une entrée d'aspiration raccordée à la chambre de procédés 1 et refoulant dans une pompe primaire 3 qui elle-même refoule à l'atmosphère par une canalisation de sortie 4 par l'intermédiaire d'un système de traitement des gaz 5.

La pompe primaire 3 est une pompe primaire sèche à vitesse variable, adaptée pour refouler à la pression atmosphérique. La pompe secondaire 2 est par exemple une pompe turbomoléculaire, adaptée pour établir la pression basse appropriée dans la chambre de procédés 1, et pour refouler à la pression d'entrée de la pompe primaire 3 par une canalisation 30.

On prévoit des moyens de commande de vitesse de la pompe primaire 3, par exemple un contrôleur 6 raccordé à la pompe primaire 3 par une ligne de commande de pompe primaire 7. La pompe primaire 3 comprend, de façon connue en soi, un dispositif d'alimentation approprié pour réaliser la vitesse variable en fonction des signaux reçus sur la ligne de commande de pompe primaire 7.

De même, on peut prévoir des moyens de commande de vitesse de la pompe secondaire 2, tels que par exemple le même contrôleur 6 raccordé à la pompe secondaire 2 par une ligne de commande de pompe secondaire 8.

Des premiers moyens analyseurs de gaz 9 sont adaptés pour analyser les gaz aspirés en amont de la pompe primaire 3, et pour produire des premiers signaux d'analyse envoyés au contrôleur 6 par une première ligne de signaux d'analyse 10. Le contrôleur 6 est programmé de façon à constituer des premiers moyens de traitement de signal pour produire un signal de commande de vitesse en fonction des premiers signaux d'analyse procurés par les premiers moyens analyseurs de gaz 9, et pour transmettre par la ligne de commande de pompe primaire 7 ledit signal de commande de vitesse au dispositif d'alimentation de la pompe primaire 3.

Pour cela, le contrôleur 6 comprend une mémoire dans laquelle est enregistrée une fonction de transfert permettant le calcul de la vitesse de pompe primaire 3 pour produire dans la chambre de procédés 1 les conditions de pression appropriées. Ainsi, les moyens de traitement implémentés dans le contrôleur 6 réalisent une correspondance relationnelle entre les premiers signaux d'analyse qui leur parviennent à leur première entrée 100 par la première ligne de signaux d'analyse 10 et le signal de commande de vitesse à leur sortie 70 raccordée à la pompe primaire 3 par la ligne de commande de pompe primaire 7, selon une fonction de transfert préalablement enregistrée et représentant, pour chaque mélange gazeux présent dans la chambre de procédés au cours d'une étape du traitement, la relation entre la vitesse de pompage, le flux de ce mélange gazeux et la pression qui en résulte dans la chambre de procédés 1.

Grâce au système d'analyse de gaz intégré dans le système de génération de vide comme représenté sur la figure 1, il devient possible de raccorder la pompe secondaire 2 à la chambre de procédés 1 par une canalisation 21 de longueur courte, généralement inférieure à 3 mètres. En réalité, il devient possible de placer la pompe secondaire 2 en position adjacente à la chambre de procédés 1, dont elle est séparée éventuellement par la canalisation 21 comportant une vanne d'isolation 11.

Selon une variante, la canalisation 21 est réduite à la vanne d'isolation 11.

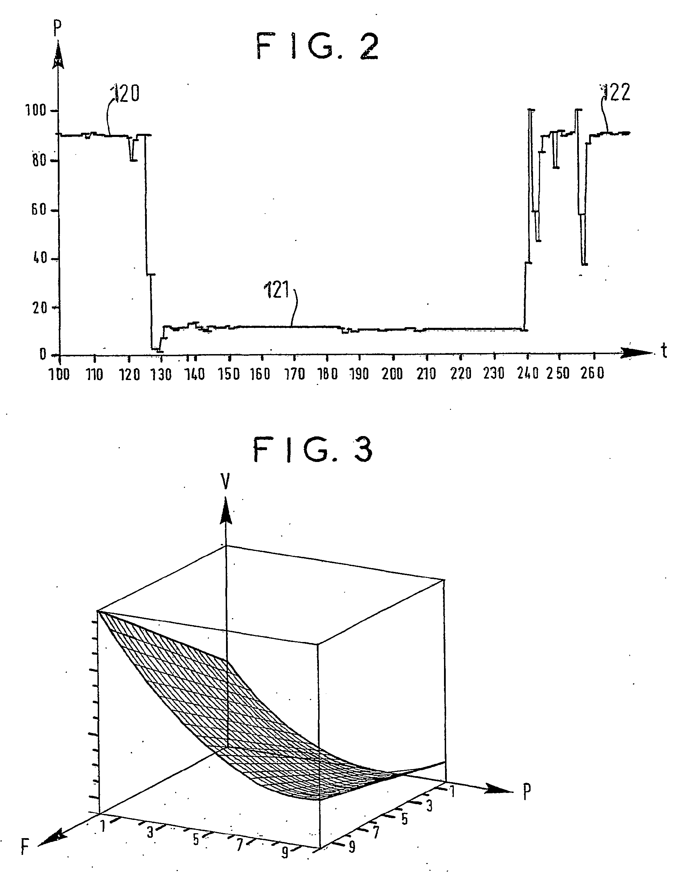

La fonction de transfert implémentée dans le contrôleur 6 est par exemple représentée sur la figure 3, pour un mélange gazeux particulier. Sur cette figure, on voit la forme d'une surface illustrant la relation dans un système tridimensionnel entre le flux gazeux présent dans la chambre et représenté selon l'axe F, la pression qui en résulte représentée selon l'axe P et la vitesse de pompage représentée selon l'axe V.

La première fonction assurée par le contrôleur 6 est d'ajuster la vitesse de pompage de manière à maintenir la pression à une valeur adaptée à chaque étape de traitement dans la chambre de procédés 1.

En outre, le contrôleur 6 utilise l'analyse des gaz aspirés procurée par les premiers moyens analyseurs de gaz 9, le résultat de l'analyse étant utilisé pour ajuster la vitesse de pompage, en fonction des gaz pompés, de manière à déterminer l'évolution de la pression dans la chambre de procédés 1 pendant les phases transitoires du traitement.

Pour l'ajustement de la vitesse de pompage en fonction des gaz pompés, on utilise ainsi la fonction de transfert préalablement enregistrée dans le contrôleur 6, fonction de transfert qui représente, pour chaque mélange gazeux présent dans la chambre de procédés 1 au cours du traitement, la relation entre la vitesse de pompage V, le flux F et la pression P qui en résulte dans la chambre de procédés 1.

Dans le mode de réalisation illustré sur la figure 1, en aval de la pompe primaire 3, se trouvent les moyens de traitement des gaz 5 aspirés raccordés à ladite pompe primaire 3 par une canalisation 31. Au refoulement de la pompe primaire 3, avant les moyens de traitement des gaz 5, on prévoit des seconds moyens analyseurs de gaz 12 qui permettent de déterminer la nature et l'état des gaz pompés, et qui produisent des seconds signaux d'analyse envoyés par une ligne de transmission 13 à des seconds moyens de traitement de signal implémentés dans le contrôleur 6. Les seconds moyens de traitement de signal, dans le contrôleur 6, sont adaptés pour produire, en fonction des signaux d'analyse reçus des seconds moyens analyseurs de gaz 12, des seconds signaux de commande pouvant être envoyés au dispositif de commande de vitesse de la pompe primaire 3 par la ligne de commande de pompe primaire 7.

Grâce aux informations données par les seconds moyens analyseurs de gaz 12, le contrôleur 6 connaît la nature et l'état des gaz pompés et adapte les paramètres de pompage afin d'optimiser le traitement réalisé par le dispositif de traitement des gaz 5. Pour cela, on prévoit, associés à la pompe primaire 3, un dispositif de contrôle de température de pompe 14, et un injecteur de gaz de dilution 15 relié au dispositif de traitement des gaz 5 par une canalisation 20. L'injecteur de gaz de dilution 15 permet d'injecter si nécessaire, et de façon contrôlée, des gaz de dilution dans la pompe primaire 3, permettant de diluer les gaz pompés et d'éviter leur condensation dans la pompe primaire 3. L'injecteur de gaz de dilution 15 et le dispositif de contrôle de température de pompe 14 sont commandés par le contrôleur 6, qui peut ainsi adapter les paramètres de pompage tels que la température du corps de pompe primaire 3 et l'injection de gaz de dilution, outre la vitesse de la pompe primaire 3. Ces possibilités permettent d'améliorer sensiblement l'efficacité des moyens de traitement des gaz 5, afin de réduire au mieux en sortie 4 la présence d'éléments toxiques.

Ainsi, le dispositif comprend des moyens de conditionnement de pompage comportant un dispositif de contrôle de température de pompe 14 associé à ladite pompe primaire 3, et un dispositif d'injection de gaz de dilution 15 dans ladite pompe primaire 3 et recevant lesdits seconds signaux de commande pour leur propre commande, de manière à optimiser l'efficacité des moyens de traitement des gaz 5.

Dans le mode de réalisation illustré sur la figure 1, on prévoit en outre des troisièmes moyens analyseurs de gaz 16 rapportés sur la canalisation 4, adaptés pour analyser les gaz en sortie des moyens de traitement des gaz 5 et pour adapter les moyens de traitement des gaz 5 eux-mêmes en fonction du résultat de ladite analyse. En pratique, les troisièmes moyens analyseurs de gaz 16 produisent des signaux envoyés au contrôleur 6 par la ligne de transmission 22, et le contrôleur 6 commande les moyens de traitement des gaz 5 par une ligne de commande de traitement de gaz 17. Ainsi, on analyse les gaz en sortie de traitement pour adapter le traitement lui-même en fonction du résultat de ladite analyse. Par exemple, on peut interrompre le pompage en cas de défaut du traitement tel que détecté par les troisièmes moyens analyseurs de gaz 16.

Les moyens analyseurs de gaz 9, 12 et 16 peuvent a priori être de tous types connus permettant une analyse rapide des gaz dans les canalisations 30, 31 et 4 de courte longueur respectivement entre la pompe secondaire 2 et la pompe primaire 3, entre la pompe primaire 3 et le dispositif de traitement des gaz 5, et en sortie du dispositif de traitement des gaz 5.

Selon un mode de réalisation, un tel moyen analyseur de gaz 9, 12 ou 16 peut comprendre un dispositif pour ioniser les gaz à analyser, constitué d'au moins une source de plasma dédiée à l'analyse et mise au contact des gaz de la canalisation, générant un plasma à partir des gaz à analyser. Cette source de plasma est alimentée par un générateur adapté au type de source de plasma choisi. Par exemple, la source de plasma peut être une source micro-onde de type cavité résonante ou de type utilisant le principe de propagation d'une surface d'onde, et le générateur est un générateur micro-onde. Dans une autre forme de réalisation, la source de plasma est une source plasma radiofréquence de type ICP (acronyme anglais de "Inductive Coupling Plasma"), et le générateur est un générateur RF (ou Radio Fréquence).

Les gaz ionisés peuvent être analysés par un dispositif d'analyse de gaz ionisé de type spectromètre optique, ayant une sonde située à proximité de la source de plasma dédiée, analysant l'évolution d'un spectre radiatif émis par le plasma généré. Les radiations émises par les atomes, molécules et ions excités par les électrons libres du plasma sont transmises au spectromètre d'émission optique, qui analyse les évolutions de ces radiations et en déduit des informations relatives aux constituants des gaz ionisés.

Le moyen analyseur de gaz 9, 12 ou 16 peut être intégré en série dans la canalisation 30, 31 ou 4 dont on souhaite contrôler les effluents gazeux, ou est rapporté sur ladite canalisation par raccord extérieur.

On comprend que le contrôleur 6 peut être réalisé de façon connue, à base d'un microprocesseur associé à des mémoires et des circuits d'entrée-sortie. Un programme adapté et des données sont enregistrés dans la mémoire du contrôleur 6 pour piloter les organes du dispositif de génération et de contrôle de vide. Dans la mémoire, on peut en particulier entrer les données de la fonction de transfert telle qu'illustrée sur la figure 3, données préalablement calculées en fonction notamment de la géométrie de la chambre de procédés 1 et des différents organes de génération de vide.

Selon l'invention, on peut avantageusement prévoir une étape préalable d'apprentissage, dans laquelle on fait varier la vitesse de pompage en présence de certains au moins des mélanges gazeux susceptibles d'être présents au cours des étapes de traitement dans la chambre de procédés 1, et on mesure le flux et la pression qui en résulte dans la chambre de procédés 1 pour déterminer ladite fonction de transfert. Grâce à cette étape d'apprentissage, le dispositif selon l'invention peut s'auto-adapter à la chambre de procédés 1. On prévoit pour cela un capteur de pression 18, disposé dans la chambre de procédés 1, et raccordé par une ligne de pression 19 au contrôleur 6. Un programme d'apprentissage est enregistré dans la mémoire du contrôleur 6, pour commander les variations de vitesse de pompe primaire 3 et/ou de pompe secondaire 2 en présence des mélanges gazeux appropriés dans la chambre de procédés 1.

La figure 2 illustre les conditions dans lesquelles est appelé à fonctionner le dispositif de pompage selon l'invention, dans une application au contrôle de l'atmosphère dans une chambre de procédés 1. La figure illustre un exemple connu de diagramme temporel de la pression en fonction du temps obtenu avec un dispositif de pompage selon l'état de la technique connu. Au cours d'une première période 120, on réalise le transfert d'un substrat dans la chambre de procédés 1. Au cours d'une seconde période 121, la pression est plus basse et on réalise alors le traitement du substrat dans la chambre de procédés 1. Cette étape de traitement peut correspondre à la présence de différents gaz de traitement. Au cours d'une troisième période 122, la pression est plus élevée et on retire le substrat hors de la chambre de procédés 1. On constate, dans ce diagramme temporel connu, la présence d'irrégularités de pression notamment au voisinage des phases transitoires du traitement. Ces irrégularités de pression induisent des turbulences et des risques de pollution de la chambre de procédés 1. L'invention permet de réduire très sensiblement, voire d'annuler, ces irrégularités de pression et les risques de pollution qui en résultent.

Le dispositif selon l'invention peut comprendre, comme illustré sur la figure 1, la pompe primaire 3 raccordée à une seule pompe secondaire 2 pour pomper les gaz de la chambre de procédés 1.

En alternative, de manière avantageuse, on peut prévoir la pompe primaire 3, avec le dispositif de traitement des gaz 5, raccordée à plusieurs pompes secondaires 2 dédiées chacune à une chambre de procédés 1 distincte.

En programmant de façon appropriée le contrôleur 6, qui commande la vitesse de la pompe primaire 3 et éventuellement de la pompe secondaire 2, ainsi que les paramètres de pompage tels que la température du corps de la pompe primaire 3 et l'injection de gaz de dilution par les dispositifs 14 et 15, on peut éviter selon l'invention les dépôts et turbulences dans la chambre de procédés 1, et on peut éviter les dépôts dans la ligne de pompage. On réalise ainsi une meilleure intégration des fonctions de pompage et de traitement des gaz, ce qui permet de réduire très sensiblement les coûts des installations de fabrication de semi-conducteurs, d'augmenter la capacité de production, d'améliorer sensiblement la flexibilité par une plus grande facilité de disposition géographique des éléments de l'unité de production de semi-conducteurs. Simultanément, on améliore sensiblement le contrôle de la fonction vide et du procédé dans la chambre de procédés, et on améliore le traitement des gaz pompés.

La figure 1 illustre un mode de réalisation avantageux de la présente invention, comprenant des moyens d'isolement permettant de réduire encore les perturbations apportées par le dispositif de pompage sur la chambre de procédés 1.

Pour cela, la pompe primaire 3, les moyens de traitement des gaz 5, et les moyens analyseurs de gaz 9, 12 et 16 sont enfermés ensemble dans une enceinte d'isolement 23. L'enceinte d'isolement 23 est une enceinte étanche qui forme un ensemble mécaniquement rigide.

De préférence, ainsi que représenté sur la figure 1, l'enceinte d'isolement 23 comprend un dispositif de contrôle et de régulation de température 24 permettant de contrôler et de réguler la température du contenu de l'enceinte d'isolement 23, afin d'éviter de transmettre aux éléments extérieurs à l'enceinte d'isolement 23, notamment à la chambre de procédés 1, des perturbations thermiques.

Egalement, de préférence, l'enceinte d'isolement 23 comprend des moyens de compensation active de vibrations 25, permettant de compenser activement les vibrations mécaniques générées par le contenu de l'enceinte d'isolement 23, en particulier par la pompe primaire 3.

Les moyens de compensation active de vibrations 25 comprennent des capteurs de vibrations associés mécaniquement à l'enceinte d'isolement 23, et des générateurs de vibrations pilotés pour produire des vibrations en opposition en phase avec celles produites par le contenu de l'enceinte d'isolement 23.

On réduit ainsi les perturbations mécaniques, thermiques et chimiques générées par le dispositif de génération de vide, qui peut donc être disposé à proximité immédiate de la chambre de procédés 1.

De préférence, ainsi que représenté sur la figure 1, l'enceinte d'isolement 23 enferme en outre le contrôleur 6 qui réalise les moyens de traitement de signal pour générer le signal de commande de vitesse de la pompe primaire 3 et/ou secondaire en fonction des signaux qu'il reçoit des moyens analyseurs de gaz 9 ou 12.

On comprendra que les différents moyens d'isolement décrits ci-dessus pourraient chacun être adaptés à une ligne de vide indépendamment de la présence ou de l'absence des moyens analyseurs de gaz et des autres moyens selon l'invention pour piloter la vitesse des pompes et les autres organes actifs en fonction de l'analyse des gaz.

Selon l'invention, le contrôleur 6 peut avantageusement être programmé de façon à piloter les organes actifs du dispositif (pompes, paramètres de pompage) de manière différente adaptée et appropriée en fonction du statut de l'équipement à chambre de procédés 1 : phase de production ; phase de test ; phase de maintenance ; phase d'attente.

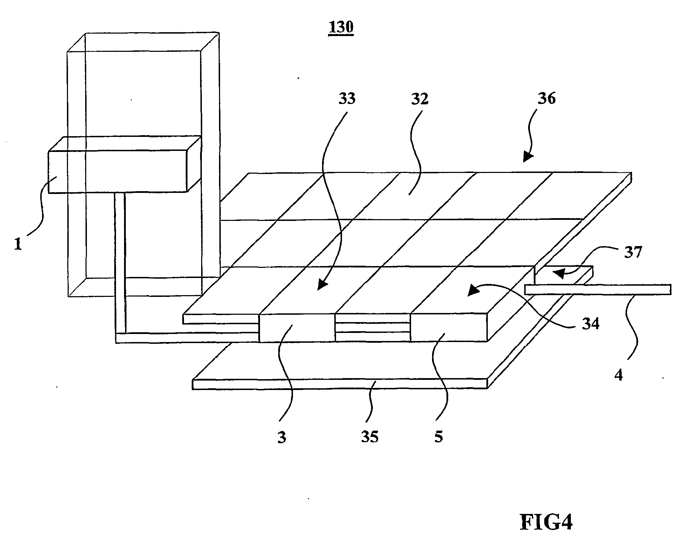

La figure 4 illustre un mode de réalisation avantageux de la présente invention, permettant de réduire significativement l'emprise au sol d'une ligne de vide et de ses composants à proximité de la chambre de procédés 1, laissant libre l'espace autour de la chambre de procédés pour permettre aux opérateurs d'intervenir sur cette chambre sans être gênés par les composants de génération de vide et de traitement des gaz.

Dans ce mode de réalisation, la chambre de procédés est contenue dans une salle 130, par exemple une salle blanche, ayant un faux-plancher 36 recouvrant un espace disponible 37. La pompe primaire 3 et les moyens de traitement des gaz 5, ainsi qu'éventuellement les moyens analyseurs de gaz 9, 12, 16, sont logés dans l'espace disponible 37 sous le faux-plancher 36, à proximité de la chambre de procédés 1. Ces composants sont fixés sous les dalles du faux-plancher 36, au niveau des fixations qui supportent les dalles.

Le faux-plancher 36 peut avantageusement comprendre des dalles amovibles 32, permettant les interventions de maintenance ou de réparation sur les éléments actifs de la ligne de vide. Selon une première possibilité, les dalles amovibles 32 peuvent simplement recouvrir la pompe primaire 3, les moyens de traitement des gaz 5 et éventuellement les moyens analyseurs de gaz 9, 12, 16.

En alternative, comme illustré sur la figure 4, la partie supérieure 33 de la pompe primaire 3 et la partie supérieure 34 des moyens de traitement des gaz 5 constituent elles-mêmes des portions de surface du faux-plancher 36.

De préférence, une plaque support 35 est disposée dans le plancher au-dessous de la pompe primaire 3 et des moyens de traitement des gaz 5, entre les piliers de fixation du faux-plancher 36, en guise de sécurité.

## Revendications

1. Procédé de conditionnement de l'atmosphère dans une chambre de procédés (1) pour le traitement d'un substrat, dans lequel on pompe les gaz hors de la chambre de procédés (1) à l'aide d'une pompe primaire (3) reliée à au moins une pompe secondaire (2) amont, **caractérisé en ce que** :
- on ajuste la vitesse des pompes de manière à maintenir la pression à une valeur adaptée à chaque étape de traitement dans la chambre de procédés (1),
- on analyse les gaz aspirés en amont de la pompe primaire (3),
- on utilise le résultat de l'analyse des gaz pompés pour ajuster la vitesse des pompes, de manière à produire dans la chambre de procédés (1) les conditions de pression appropriées aux phases du traitement.

2. Procédé selon la revendication 1, **caractérisé en ce que**, pour l'ajustement de la vitesse des pompes en fonction du résultat de l'analyse des gaz pompés, on utilise une fonction de transfert préalablement enregistrée représentant, pour chaque mélange gazeux présent dans la chambre de procédés au cours du traitement, la relation entre la vitesse des pompes (V), le flux (F) de mélange gazeux présent, et la pression (P) qui en résulte dans la chambre de procédés (1).

3. Procédé selon l'une des revendications 1 ou 2, **caractérisé en ce que** ladite au moins une pompe secondaire (2) est raccordée à la chambre de procédés (1) par une canalisation (21).

4. Procédé selon l'une des revendications 1 ou 2, **caractérisé en ce que** ladite au moins une pompe secondaire (2) est adjacente à la chambre de procédés (1).

5. Procédé selon l'une quelconque des revendications 1 à 4, **caractérisé en ce que** :
- on traite les gaz en aval de la pompe primaire (3),
- on analyse les gaz au refoulement de la pompe primaire (3) avant traitement des gaz, pour connaître leur nature et leur état et pour adapter des paramètres de pompage, constitués parmi la température de la pompe primaire (3), une injection de gaz de dilution dans la pompe primaire, la vitesse de la pompe primaire (3), afin d'optimiser l'efficacité de leur traitement.

6. Procédé selon l'une quelconque des revendications 1 à 5, **caractérisé en ce qu'**on analyse les gaz en sortie de traitement pour adapter le traitement en fonction du résultat de ladite analyse.

7. Procédé selon la revendication 6, **caractérisé en ce qu'**on interrompt le pompage en cas de défaut de traitement.

8. Procédé selon la revendication 2, **caractérisé en ce que**, au cours d'une étape préalable d'apprentissage, on fait varier la vitesse de pompage en présence de certains au moins des mélanges gazeux susceptibles d'être présents au cours des étapes de traitement dans la chambre de procédés (1) et on mesure la pression qui en résulte dans la chambre de procédés (1), pour déterminer ladite fonction de transfert.

9. Dispositif de conditionnement de l'atmosphère dans une chambre de procédés (1) pour le traitement d'un substrat, pour la mise en oeuvre du procédé selon l'une quelconque des revendications 1 à 4, comprenant une ligne de pompage comportant une pompe primaire (3) et au moins une une pompe secondaire (2) amont, **caractérisé en ce que** :
- ladite pompe primaire est une pompe primaire sèche à vitesse variable,
et **en ce que** le dispositif comprend :
- des moyens de commande de vitesse de pompe primaire (6, 7),
- des premiers moyens analyseurs de gaz (9) adaptés pour analyser les gaz aspirés en amont de la pompe primaire (3), et pour produire des premiers signaux d'analyse de gaz,
- des premiers moyens de traitement de signal (6) pour produire un signal de commande de vitesse en fonction desdits premiers signaux d'analyse de gaz procurés par les premiers moyens analyseurs de gaz (9), et pour transmettre ledit signal de commande de vitesse aux moyens de commande de vitesse de pompe primaire (6, 7).

10. Dispositif selon la revendication 9, **caractérisé en ce que** les premiers moyens de traitement de signal (6) réalisent une correspondance relationnelle entre les premiers signaux d'analyse à leur entrée (100) et le signal de commande de vitesse à leur sortie (70), à partir d'une fonction de transfert préalablement enregistrée représentant, pour chaque mélange gazeux présent dans la chambre de procédés (1) au cours du traitement du substrat, une relation entre la vitesse de pompage (V), le flux (F) du mélange gazeux présent, et la pression (P) qui en résulte dans la chambre de procédés (1).

11. Dispositif selon l'une des revendications 9 ou 10, **caractérisé en ce que** la pompe secondaire (2) est raccordée à la chambre de procédés (1) par une canalisation (21) de longueur généralement inférieure à 3 mètres.

12. Dispositif selon l'une quelconque des revendications 9 à 11, **caractérisé en ce que** la pompe secondaire (2) est adjacente à la chambre de procédés (1).

13. Dispositif selon l'une quelconque des revendications 9 à 12, **caractérisé en ce qu'**il comprend :
- en aval de la pompe primaire (3), des moyens de traitement des gaz (5) aspirés,
- au refoulement de la pompe primaire (3), des seconds moyens analyseurs de gaz (12) déterminant la nature et l'état des gaz pompés et produisant des seconds signaux d'analyse de gaz,
- des seconds moyens de traitement de signal (6) pour produire, en fonction des seconds signaux d'analyse de gaz, des seconds signaux de commande de la vitesse de la pompe primaire (3)

14. Dispositif selon la revendication 13, **caractérisé en ce qu'**il comprend en outre des moyens de conditionnement de pompage comportant un dispositif de contrôle de température de pompe (14) associé à ladite pompe primaire (3) et un dispositif d'injection de gaz de dilution (15) dans ladite pompe primaire (3) et recevant lesdits seconds signaux de commande pour leur propre commande, de manière à optimiser l'efficacité des moyens de traitement des gaz (5).

15. Dispositif selon l'une des revendications 13 ou 14, **caractérisé en ce qu'**il comprend des troisièmes moyens analyseurs de gaz (16), adaptés pour analyser les gaz en sortie des moyens de traitement des gaz (5) et pour adapter les moyens de traitement des gaz (5) en fonction de ladite analyse.

16. Dispositif selon l'une quelconque des revendications 9 à 15, **caractérisé en ce que** la pompe primaire (3), les moyens de traitement des gaz (5), et les moyens analyseurs de gaz (9, 12, 16) sont enfermés ensemble dans une enceinte d'isolement (23).

17. Dispositif selon la revendication 16, **caractérisé en ce que** l'enceinte d'isolement (23) comprend un dispositif de contrôle et de régulation de température (24) pour contrôler et réguler la température du contenu de l'enceinte d'isolement (23).

18. Dispositif selon l'une des revendications 16 ou 17, **caractérisé en ce que** l'enceinte d'isolement (23) comprend des moyens de compensation active de vibrations (25) pour compenser les vibrations mécaniques générées par le contenu de l'enceinte d'isolement (23).

19. Dispositif selon l'une quelconque des revendications 16 à 18, **caractérisé en ce que** l'enceinte d'isolement (23) enferme en outre un contrôleur (6), constituant lesdits moyens de traitement de signal pour générer le signal de commande de vitesse de pompe primaire et/ou secondaire en fonction des signaux reçus des moyens analyseurs de gaz (9 ; 12).

20. Dispositif selon l'une quelconque des revendications 9 à 19, **caractérisé en ce qu'**il comprend en outre un contrôleur (6) programmé de façon à piloter les organes actifs du dispositif (pompes, paramètres de pompage) de manière différente adaptée et appropriée en fonction du statut de l'équipement à chambre de procédés (1) : phase de production ; phase de test ; phase de maintenance ; phase d'attente.

21. Dispositif selon l'une quelconque des revendications 9 à 15, **caractérisé en ce que** :
- la chambre de procédés (1) est contenue dans une salle (130) ayant un faux-plancher (36) recouvrant un espace disponible (37),
- la pompe primaire (3), les moyens de traitement des gaz (5) et les moyens analyseurs de gaz (9, 12, 16) sont logés dans l'espace disponible (37) sous le faux-plancher (36), à proximité de la chambre de procédés (1).

22. Dispositif selon la revendication 21, **caractérisé en ce que** le faux-plancher (36) comprend des dalles amovibles (32) recouvrant la pompe primaire (3), les moyens de traitement des gaz (5) et les moyens analyseurs de gaz (9, 12, 16).

23. Dispositif selon la revendication 21, **caractérisé en ce que** la partie supérieure (33) de la pompe primaire (3) et la partie supérieure (34) des moyens de traitement des gaz (5) constituent elles-mêmes des portions de surface du faux-plancher (36).

24. Dispositif selon l'une quelconque des revendications 21 à 23, **caractérisé en ce qu'**une plaque support (35) est disposée dans le plancher au-dessous de la pompe primaire (3) et des moyens de traitement des gaz (5).

## Claims

1. Method of conditioning the atmosphere in a process chamber (1) for processing a substrate, wherein the gases are pumped out from the process chamber (1) by means of a primary pump (3) connected to at least one upstream secondary pump (2), **characterised in that**:
- the speed of the pumps is adjusted such as to maintain the pressure in the process chamber (1) at a value adapted to each processing step,
- the gases aspirated on the upstream side of the primary pump (3) are analysed, and
- the result of the analysis of the pumped gases is used to adjust the speed of the pumps in such a manner as to produce in the process chamber (1) the pressure conditions appropriate to the processing phases.

2. Method according to claim 1, **characterised in that** a previously recorded transfer function is used to adjust the speed of the pumps as a function of the result of the analysis of the pumped gases, that transfer function representing, for each gas mixture present in the process chamber during processing, the relationship between the speed of the pumps (V), the flow (F) of the gas mixture present, and the resulting pressure (P) in the process chamber (1).

3. Method according to either claim 1 or claim 2, **characterised in that** said at least one secondary pump (2) is connected to the process chamber (1) by a pipe (21).

4. Method according to either claim 1 or claim 2, **characterised in that** said at least one secondary pump (2) is adjacent to the process chamber (1).

5. Method according to any one of claims 1 to 4, **characterised in that**:
- the gases are processed on the downstream side of the primary pump (3), and
- the gases are analysed at the discharge from the primary pump (3), before processing the gases, to determine their nature and their state and to adapt the pumping parameters, including the temperature of the primary pump (3), injection of diluting gas into the primary pump and the speed of the primary pump (3), to optimise processing efficacy.

6. Method according to any one of claims 1 to 5, **characterised in that** the gases are analysed after processing to adapt the processing as a function of the result of said analysis.

7. Method according to claim 6, **characterised in that** pumping is interrupted in the event of a processing error.

8. Method according to claim 2, **characterised in that**, during a preliminary training step, the pumping speed is varied in the presence of at least some of the gas mixtures liable to be present in the process chamber (1) during processing steps and the resulting pressure in the process chamber (1) is measured to determine said transfer function.

9. System for conditioning the atmosphere in a process chamber (1) for processing a substrate by the method according to any one of claims 1 to 4, including a pumping line including a primary pump (3) and at least one upstream secondary pump (2), **characterised in that**:
- said primary pump is a variable speed dry pump, and
**in that** the system includes:
- speed control means for the primary pump (6, 7),
- first gas analyser means (9) adapted to analyse the gases aspirated on the upstream side of the primary pump (3) and to produce first gas analysis signals, and
- first signal processing means (6) for producing a speed control signal as a function of said first gas analysis signals provided by the first gas analyser means (9) and for transmitting said speed control signal to the speed control means of the primary pump (6, 7).

10. System according to claim 9, **characterised in that** the first signal processing means (6) establish a relational correspondence between the first analysis signals at their input (100) and the speed control signal at their output (70) based on a previously stored transfer function representing for each gas mixture present in the process chamber (1) during processing of the substrate a relationship between the pumping speed (V), the flow (F) of the gas mixture present and the resulting pressure (P) in the process chamber (1).

11. System according to either claim 9 or claim 10, **characterised in that** the secondary pump (2) is connected to the process chamber (1) by a pipe (21) that is generally less than 3 metres long.

12. System according to any one of claims 9 to 11, **characterised in that** the secondary pump (2) is adjacent the process chamber (1).

13. System according to any one of claims 9 to 12, **characterised in that** it includes:
- aspirated gas processing means (5) on the downstream side of the primary pump (3),
- at the discharge of the primary pump (3), second gas analyser means (12) for determining the nature and the state of the pumped gases and producing second gas analysis signals, and
- second signal processor means (6) for producing, as a function of the second gas analysis signals, second signals for controlling the speed of the primary pump (3).

14. System according to claim 13, **characterised in that** it further includes pumping conditioning means including a pump temperature control system (14) associated with said primary pump (3) and a system (15) for injecting diluting gas into said primary pump (3), said systems receiving said second control signals so that they are controlled in such a manner as to optimise the efficacy of the gas processor means (5).

15. System according to either claim 13 or claim 14, **characterised in that** it includes third gas analyser means (16) adapted to analyse the gases at the outlet of the gas processing means (5) and to adapt the gas processing means (5) as a function of said analysis.

16. System according to any one of claims 9 to 15, **characterised in that** the primary pump (3), the gas processing means (5) and the gas analyser means (9, 12, 16) are enclosed together in an isolating enclosure (23).

17. System according to claim 16, **characterised in that** the isolation enclosure (23) includes a temperature control and regulation system (24) for controlling and regulating the temperature of the contents of the isolation enclosure (23).

18. System according to either claim 16 or claim 17, **characterised in that** the isolation enclosure (23) includes active vibration compensator means (25) for compensating mechanical vibrations generated by the contents of the isolation enclosure (23).

19. System according to any one of claims 16 to 18, **characterised in that** the isolation enclosure (23) further encloses a control unit (6) constituting said signal processing means for generating the speed control signal for the primary pump and/or the secondary pump as a function of signals received by the gas analyser means (9; 12).

20. System according to any one of claims 9 to 19, **characterised in that** it further includes a control unit (6) programmed to drive the active units of the system (pumps, pumping parameters) in a different, adapted and appropriate manner as a function of the status of the process chamber equipment (1): production phase; test phase; maintenance phase; waiting phase.

21. System according to any one of claims 9 to 15, **characterised in that**:
- the process chamber (1) is contained in a room (130) having a raised floor (36) covering an available space (37), and
- the primary pump (3), the gas processing means (5) and the gas analyser means (9, 12, 16) are accommodated in the available space (37) under the raised floor (36) in the vicinity of the process chamber (1).

22. System according to claim 21, **characterised in that** the raised floor (36) includes removable floor slabs (32) covering the primary pump (3), the gas processor means (5) and the gas analyser means (9, 12, 16).

23. System according to claim 21, **characterised in that** the upper portion (33) of the primary pump (3) and the upper portion (34) of the gas processing means (5) themselves constitute portions of the surface of the raised floor (36).

24. System according to any one of claims 21 to 23, **characterised in that** a support plate (35) is disposed in the floor under the primary pump (3) and the gas processor means (5).

## Patentansprüche

1. Verfahren zur Konditionierung der Atmosphäre in einem Prozessraum (1) für die Behandlung eines Substrats, bei dem die Gase mit Hilfe einer Primärpumpe (3), die mit mindestens einer vorgelagerten Sekundärpumpe (2) verbunden ist, aus dem Prozessraum (1) herausgepumpt werden, **dadurch gekennzeichnet, dass**:
- die Geschwindigkeit der Pumpen so eingestellt wird, dass der Druck auf einem jeweils für die Behandlungsstufe im Prozessraum (1) geeigneten Wert gehalten wird,
- die angesaugten Gase oberhalb der Primärpumpe (3) analysiert werden,
- das Ergebnis der Analyse der abgepumpten Gase dazu verwendet wird, die Geschwindigkeit der Pumpen einzustellen, so dass im Prozessraum (1) die für die Behandlungsphasen geeigneten Druckbedingungen erzeugt werden.

2. Verfahren gemäß Anspruch 1, **dadurch gekennzeichnet, dass** für die Einstellung der Geschwindigkeit der Pumpen in Abhängigkeit vom Ergebnis der Analyse der gepumpten Gase eine zuvor gespeicherte Übertragungsfunktion verwendet wird, die für jedes im Prozessraum während der Behandlung vorhandene Gasgemisch das Verhältnis zwischen der Geschwindigkeit der Pumpen (V), dem Fluss (F) des vorhandenen Gasgemischs und dem Druck (P), der sich daraus im Prozessraum ergibt, darstellt.

3. Verfahren gemäß einem der Ansprüche 1 oder 2, **dadurch gekennzeichnet, dass** diese mindestens eine Sekundärpumpe (2) mit dem Prozessraum über eine Leitung (21) verbunden ist.

4. Verfahren gemäß einem der Ansprüche 1 oder 2, **dadurch gekennzeichnet, dass** diese mindestens eine Sekundärpumpe (2) an den Prozessraum (1) angrenzt.

5. Verfahren gemäß einem der Ansprüche 1 bis 4, **dadurch gekennzeichnet, dass**:
- die Gase unterhalb der Primärpumpe (3) behandelt werden,
- die Gase an der Druckseite der Primärpumpe (3) vor der Behandlung der Gase analysiert werden, um deren Beschaffenheit und ihren Zustand in Erfahrung zu bringen und um die Pumpparameter anzupassen, die bestehen aus Temperatur der Primärpumpe (3), Einpressen von Verdünnungsgasen in die Primärpumpe, Geschwindigkeit der Primärpumpe (3), mit dem Ziel, die Effektivität ihrer Behandlung zu optimieren.

6. Verfahren gemäß einem der Ansprüche 1 bis 5, **dadurch gekennzeichnet, dass** die Gase am Ausgang der Behandlung analysiert werden, um die Behandlung in Abhängigkeit vom Ergebnis dieser Analyse anzupassen.

7. Verfahren gemäß Anspruch 6, **dadurch gekennzeichnet, dass** das Pumpen im Falle eines Behandlungsfehlers unterbrochen wird.

8. Verfahren gemäß Anspruch 2, **dadurch gekennzeichnet, dass** im Verlauf eines vorangehenden Lernschritts die Pumpgeschwindigkeit bei Vorliegen von mindestens einigen der Gasgemische, die im Verlauf der Behandlungsstufen im Prozessraum (1) vorhanden sein können, verändert wird, und man den sich daraus im Prozessraum (1) ergebenden Druck misst, um diese Übertragungsfunktion festzulegen.

9. Vorrichtung zur Konditionierung der Atmosphäre in einem Prozessraum (1) für die Behandlung eines Substrats, für die Ausführung des Prozesses gemäß einem der Ansprüche 1 bis 4, beinhaltend eine Pumpleitung, die eine Primärpumpe (3) und mindestens eine oberhalb gelegene Sekundärpumpe (2) beinhaltet, **dadurch gekennzeichnet, dass**:
- diese Primärpumpe eine Trocken-Primärpumpe mit veränderlicher Geschwindigkeit ist,
und **dadurch**, dass die Vorrichtung Folgendes beinhaltet:
- Mittel zur Steuerung der Geschwindigkeit der Primärpumpe (6, 7),
- erste Mittel zur Gasanalyse (9), die für die Analyse der oberhalb der Primärpumpe (3) angesaugten Gase geeignet sind, und für die Erzeugung erster Gasanalysesignale,
- erste Mittel zur Signalverarbeitung (6) zur Erzeugung eines Signals zur Geschwindigkeitssteuerung in Abhängigkeit von diesen ersten Gasanalysesignalen, die von den ersten Gasanalysemitteln (9) verschafft werden, und zur Übertragung dieses Signals zur Geschwindigkeitssteuerung an die Mittel zur Steuerung der Geschwindigkeit der Primärpumpe (6, 7).

10. Vorrichtung gemäß Anspruch 9, **dadurch gekennzeichnet, dass** die ersten Mittel zur Signalverarbeitung (6) eine relationale Übereinstimmung zwischen den ersten Analysesignalen in ihrem Eingang (100) und dem Geschwindigkeitssteuerungssignal an ihrem Ausgang (70) herstellen, und zwar ausgehend von einer zuvor gespeicherten Übertragungsfunktion, welche für jedes Gasgemisch, das im Lauf der Behandlung des Substrats im Prozessraum (1) vorliegt, ein Verhältnis darstellt zwischen der Pumpgeschwindigkeit (V), dem Fluss (F) des vorhandenen Gasgemischs und dem sich daraus im Prozessraum (1) ergebenden Druck (P).

11. Vorrichtung gemäß einem der Ansprüche 9 oder 10, **dadurch gekennzeichnet, dass** die Sekundärpumpe (2) an den Prozessraum (1) über eine im Allgemeinen weniger als 3 Meter lange Leitung (21) angeschlossen ist.

12. Vorrichtung gemäß einem der Ansprüche 9 bis 11, **dadurch gekennzeichnet, dass** die Sekundärpumpe (2) an den Prozessraum (1) angrenzt.

13. Vorrichtung gemäß einem der Ansprüche 9 bis 12, **dadurch gekennzeichnet, dass** sie Folgendes beinhaltet:
- unterhalb der Primärpumpe (3) Mittel zur Behandlung der angesaugten Gase (5),
- an der Druckseite der Primärpumpe (3) zweite Mittel zur Gasanalyse (12), welche die Beschaffenheit und den Zustand der gepumpten Gase bestimmen und zweite Gasanalysesignale erzeugen,
- zweite Mittel zur Signalverarbeitung (6), um in Abhängigkeit von den zweiten Gasanalysesignalen zweite Signale zur Steuerung der Geschwindigkeit der Primärpumpe (3) zu erzeugen.

14. Vorrichtung gemäß Anspruch 13, **dadurch gekennzeichnet, dass** sie außerdem Mittel zur Pumpkonditionierung beinhaltet, die eine Vorrichtung zur Pumpentemperaturüberwachung (14) verbunden mit dieser Primärpumpe (3) und eine Vorrichtung zum Einpressen von Verdünnungsgas (15) in diese Primärpumpe (3) beinhalten und diese zweiten Steuerungssignale für ihre eigene Steuerung erhalten, so dass die Effektivität der Mittel zur Gasbehandlung (5) optimiert wird.

15. Vorrichtung gemäß einem der Ansprüche 13 oder 14, **dadurch gekennzeichnet, dass** sie dritte Gasanalysemittel (16) beinhaltet, die geeignet sind, die Gase am Ausgang der Gasbehandlungsmittel (5) zu analysieren und die Gasbehandlungsmittel (5) in Abhängigkeit von dieser Analyse anzupassen.

16. Vorrichtung gemäß einem der Ansprüche 9 bis 15, **dadurch gekennzeichnet, dass** die Primärpumpe (3), die Gasbehandlungsmittel (5) und die Gasanalysemittel (9, 12, 16) zusammen in einer Isolierkammer (23) eingeschlossen sind.

17. Vorrichtung gemäß Anspruch 16, **dadurch gekennzeichnet, dass** die Isolierkammer (23) eine Vorrichtung zur Temperatur-Überwachung und - Regelung (24) zum Überwachen und Regeln der Temperatur des Inhalts der Isolierkammer (23) beinhaltet.

18. Vorrichtung gemäß einem der Ansprüche 16 oder 17, **dadurch gekennzeichnet, dass** die Isolierkammer (23) Mittel zur aktiven Schwingungskompensation (25) zum Ausgleichen der mechanischen Schwingungen, die vom Inhalt der Isolierkammer (23) erzeugt werden, beinhaltet.

19. Vorrichtung gemäß einem der Ansprüche 16 bis 18, **dadurch gekennzeichnet, dass** die Isolierkammer (23) außerdem eine Steuereinrichtung (6) einschließt, welche diese Signalverarbeitungsmittel zur Erzeugung des Signals für die Steuerung der Geschwindigkeit der Primärpumpe und/oder Sekundärpumpe in Abhängigkeit von den Signalen, die von den Gasanalysemitteln (9; 12) empfangen wurden, bilden.

20. Vorrichtung gemäß einem der Ansprüche 9 bis 19, **dadurch gekennzeichnet, dass** sie außerdem eine Steuereinrichtung (6) beinhaltet, die so programmiert ist, dass sie die aktiven Organe der Vorrichtung (Pumpen, Pumpparameter) auf andere angepasste und geeignete Weise in Abhängigkeit vom Status der Prozessraumausrüstung (1) steuert; Produktionsphase; Testphase; Wartungsphase; Wartephase.

21. Vorrichtung gemäß einem der Ansprüche 9 bis 15, **dadurch gekennzeichnet, dass**:
- der Prozessraum (1) in einem Raum (130) enthalten ist, der eine Zwischendecke (36) hat, die einen verfügbaren Platz (37) abdeckt,
- die Primärpumpe (3), die Gasbehandlungsmittel (5) und die Gasanalysemittel (9, 12, 16) in dem verfügbaren Platz (37) unter der Zwischendecke (36) in der Nähe des Prozessraums (1) untergebracht sind.

22. Vorrichtung gemäß Anspruch 21, **dadurch gekennzeichnet, dass** die Zwischendecke (36) abnehmbare Platten (32) beinhaltet, welche die Primärpumpe (3), die Gasbehandlungsmittel (5) und die Gasanalysemittel (9, 12, 16) abdecken.

23. Vorrichtung gemäß Anspruch 21, **dadurch gekennzeichnet, dass** der obere Teil (33) der Primärpumpe (3) und der obere Teil (34) der Gasbehandlungsmittel (5) selbst Oberflächenanteile der Zwischendecke (36) sind.

24. Vorrichtung gemäß einem der Ansprüche 21 bis 23, **dadurch gekennzeichnet, dass** eine Stützplatte (35) im Fußboden unter der Primärpumpe (3) und den Gasbehandlungsmitteln (5) angeordnet ist.
